**Europäisches Patentamt**

**European Patent Office**

**Office européen des brevets**

(11) Veröffentlichungsnummer: **0 046 232**
A1

(12) **EUROPÄISCHE PATENTANMELDUNG**

(21) Anmeldenummer: **81106084.7**

(22) Anmeldetag: **04.08.81**

(51) Int. Cl.³: **H 03 K 13/18**, G 01 D 5/249

(30) Priorität: **14.08.80 DE 3030733**

(43) Veröffentlichungstag der Anmeldung: **24.02.82**
**Patentblatt 82/8**

(84) Benannte Vertragsstaaten: **CH FR GB LI NL SE**

(71) Anmelder: **Richter, Hans, Oberländer Strasse 123,**
**D-Augsburg (DE)**

(72) Erfinder: **Richter, Hans, Oberländer Strasse 123,**
**D-Augsburg (DE)**

(74) Vertreter: **Charrier, Rolf, Dipl.-Ing.,**
**Postfach 260 Rehlingenstrasse 8,**
**D-8900 Augsburg 31 (DE)**

(54) **Winkelkodiervorrichtung.**

㊵ Bei einer Winkelkodiervorrichtung mit mehreren koaxial angeordneten Kodierscheiben 2, 9, 10 weisen diese
geringfügig unterschiedliche Durchmesser und somit unterschiedliche Umfänge auf. Mit den gezahnten Umfängen
der Kodierscheiben 2, 9, 10 steht in Eingriff ein Zahnriemen 12, welcher über zwei Umlenkrollen 13, 14 geführt ist.
Diese Umlenkrollen 13, 14 weisen durchgehend konstante
Durchmesser auf und sind mit ihren Achsen geringfügig
schräg zur Achse der Kodierscheiben 2, 9, 10 angeordnet.

- 1 -

## Winkelkodiervorrichtung

Die Erfindung betrifft eine Winkelkodiervorrichtung mit
mindestens zwei koaxial angeordneten Kodierscheiben, deren
Kodes getrennt abgelesen werden, die an ihrem Umfang gezahnt und über ein Getriebe miteinander verbunden sind.

Bei einer bekannten Winkelkodiervorrichtung ist mit jeder
Kodierscheibe verbunden ein Zahnrad, das mit einem Ritzel
in Eingriff steht, welches seinerseits in Eingriff steht
mit einem Zahnrad der nächstfolgenden Kodierscheibe. Ist
eine weitere dritte oder sind weitere Kodierscheiben vorhanden, sind diese jeweils auf die vorgenannte Weise miteinander verbunden. Es ist auf diese Weise möglich, die
Winkelstellung einer Welle, die eine der Kodierscheiben
antreibt, über eine Vielzahl von Umdrehungen hinweg zu
erfassen. Müssen sehr viele Umdrehungen erfaßt werden,
sind die Getriebe mehrstufig ausgeführt, wodurch der
Kodierer groß und teuer wird.

Bei derartigen Vorrichtungen ist nachteilig, daß bei
hohen Drehgeschwindigkeiten der Welle oder bei einer
hohen Beschleunigung bzw. Verzögerung der Welle die
Zähne der Ritzel starken Belastungen ausgesetzt werden,
so daß diese Ritzel sehr rasch verschleißen bzw. ihre Zähne brechen können. Dieser Nachteil tritt auf, selbst
wenn die Kodierscheiben einwandfrei gelagert sind und
eine geringe Drehmasse haben. Insbesondere bei mehrstufigen Getrieben macht sich das Zahnspiel störend bei der
Kodeablesung bemerkbar. Bei raschen hochfrequenten Regelvorgängen führt das Zahnspiel zum Ausschlagen der Getriebe.

Bei einer weiteren Winkelkodiervorrichtung der eingangs
genannten Art sind benachbarte Kodierscheiben verbunden
über einen Rollenzählwerksantrieb, der beispielsweise
bewirkt, daß bei einer Umdrehung der einen Scheibe um
$360^{\circ}$ die nächste Scheibe um zwei Teilungen weitergeschaltet wird. Es handelt sich also hierbei um eine schrittweise Weiterschaltung der zweiten Kodierscheibe nach jeweils $180^{\circ}$ Umdrehung der ersten Kodierscheibe. Auch hier
ist der Nachteil zu verzeichnen, daß das Ritzel und/oder
die Schaltzähne des Rollenzählwerkantriebs bei hohen Beschleunigungen bzw. Verzögerungen bzw. bei hohen Drehzahlen der Welle, deren Winkelstellung zu messen ist,
zerstört werden. Im Bereich der Weiterschaltung der zweiten Kodierscheibe versagt die Kodeablesung bei raschen
hochfrequenten Regelvorgängen.

Es besteht die Aufgabe, eine Winkelkodiervorrichtung der
eingangs genannten Art so zu verbessern, daß sich die
Kodierscheiben pro Umdrehung nur relativ wenig zueinander
verdrehen und    Beschädigungen des Getriebes bei hohen
Drehzahlen und hohen positiven oder negativen Beschleunigungen nicht auftreten.

Gelöst wird diese Aufgabe mit den Merkmalen des Anspruches
1. Vorteilhafte Ausgestaltungen sind den Unteransprüchen
entnehmbar.

Insbesondere durch die Verwendung eines Zahnriemens wird erreicht,
daß jeweils eine Vielzahl von Zähnen des Zahnriemens
im Eingriff stehen mit den Zähnen der Kodierscheibe.
Die Belastung, die auf den einzelnen Zahn ausgeübt wird,
ist hierdurch wesentlich geringer als dies bei Verwendung
eines Ritzels der Fall ist. Außerdem entsteht der Vorteil,
daß die Zähne im Vergleich zu einem Ritzel sehr flach ausgebildet werden können, so daß eine Bruchgefahr ausgeschlossen ist. Infolge der Elastizität des Zahnriemens
arbeitet die Winkelkodiervorrichtung spielfrei und geräuscharm.

Ausführungsbeispiele der Erfindung werden nachfolgend anhand der Zeichnungen näher erläutert. Es zeigen:

Fig. 1          einen Schnitt durch eine erste
                Ausführungsform der Vorrichtung ,

Fig. 2          eine stirnseitige Ansicht auf die
                Vorrichtung nach Fig. 1,

Fig. 3          einen Schnitt durch eine Umlenkrolle,

Fig. 4          einen Schnitt durch eine zweite
                Ausführungsform,

Fig. 5          eine Draufsicht auf den Zahnriemen
                nach Fig. 4,

Fig. 6          einen Schnitt durch eine dritte Ausführungsform und

Fig. 7          einen Querschnitt durch diese dritte Ausführungsform im Bereich der ersten Kodierscheibe.

Die Welle 1, deren Winkelstellung zu messen ist, ist starr
verbunden mit einer ersten Kodierscheibe 2. Die Welle 1
ist beispielsweise über Kugellager 3, 4 in einem Gehäuse
5 gelagert. In diesem Gehäuse 5 starr angeordnet sind
Abtastorgange 6, die dazu dienen, die auf den Kodierscheiben angeordneten Kodes 7 abzutasten.

Auf der Welle 1 sind über Kugellager 8 beispielsweise
zwei weitere Kodierscheiben 9, 10 gelagert. Diesen Kodierscheiben 9, 10 sind ebenfalls Abtastorgane 6 zum Abtasten
der Kodes zugeordnet. Die Abtastung kann beispielsweise
elektrooptisch, induktiv oder kapazitiv erfolgen.

Jede Kodierscheibe 2, 9, 10 weist an ihrem Umfang eine
Verzahnung 11 auf. Die Verzahnungen 11 der Kodierscheiben
2, 9, 10 können jeweils die gleiche Teilung jedoch unterschiedliche Zähnezahlen haben, was bedeutet, daß die Kodierscheiben 2, 9, 10 unterschiedlichen Durchmesser haben. Es
genügt hierbei, wenn die Zähnezahlen benachbarter Kodierscheiben  um einen Zahn differieren.

Mit allen drei Kodierscheiben 2, 9, 10 steht in Eingriff
ein Zahnriemen 12. Dieser Zahnriemen ist über zwei Umlenkrollen 13, 14 geführt, die bewirken, daß der Zahriemen 12 über einen Teil seines Umfangs in Eingriff gehalten wird mit einem Teil des Umfangs der Kodierscheiben
2, 9, 10. Da die Durchmesser der Kodierscheiben 2, 9, 10
unterschiedlich sind, ist der Zahnriemen 12 leicht zur
Achse der Welle 1 geneigt. Die Eingriffsfläche 15 des
Zahnriemens 12 ist also beispielsweise um einen Winkel
von $3^o$ zur Achse der Welle 1 geneigt. Dementsprechend
sind die Achsen 16 der Umlenkrollen 13 bzw. 14 zur Achse
der Welle 1 geneigt. Die Zahnteilung des Zahnriemens 12 entspricht der Zahnteilung der Kodierscheiben 2, 9, 10, d.h.
der Modul der Verzahnungen ist bei jeder Verzahnung gleich.
Weisen die Zähnezahlen benachbarter Kodierscheiben eine
Differenz um einen Zahn auf, dann führt die Kodierscheibe
9 eine volle Umdrehung plus einem Winkelweg einer Zahnteilung aus, wenn die Kodierscheibe 2 eine Umdrehung von
360° ausführt. Entsprechend führt die Kodierscheibe 10
eine volle Umdrehung zuzüglich einem Winkelweg entsprechend
von zwei Zahnteilungen aus, wenn die Scheibe 2 eine volle
Umdrehung ausführt.

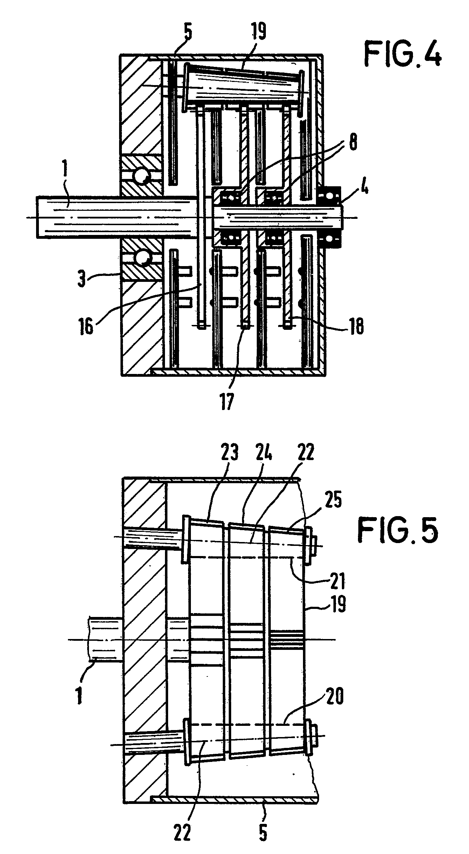

Die Anordnung kann auch so getroffen sind, daß gemäß
Fig. 4 die Kodierscheiben 16, 17, 18 untereinander gleichen
Durchmesser aufweisen und der Zahnriemen 19 kegelförmig
ausgebildet ist. Seine Umlenkrollen 20, 21 sind ebenfalls
kegelförmig ausgebildet, wobei die Drehachsen 22 wiederum
schräg zur Achse der Welle 1 verlaufen.

Die Verzahnung des Zahnriemens 19 ist in drei Bereiche
23, 24, 25 eingeteilt. Diese Zahnbereiche können unterschiedliche Teilungen haben, wobei die Teilung des Zahnbereichs
23 derjenigen der Verzahnung der Scheibe 16, die Teilung des
Bereichs 24 derjenigen der Scheibe 17 und die Teilung
des Bereichs 25 derjenigen der Verzahnung der Scheibe 18
entspricht.  Auf diese Weise kann der gleiche Effekt erreicht werden, wie er anhand der Scheiben 2, 9, 10 ceschrieben wurde. Bei der Ausführungsform nach den Fig.
4 und 5 ist  hierbei der Eingriff zwischen dem Zahnriemen
19 und den Scheiben 16, 17, 18 vergleichbar mit dem
Eingriff zwischen einem Zahnrad und einem Kegelrad.

Es lassen sich somit Winkelkodiervorrichtungen realisieren mit einstufig kleinen Übersetzungen bei kleiner Bauweise. Die Übersetzungen zwischen den einzelnen Kodierscheiben entsprechen nicht derjenigen eines Stirnradgetriebes , sondern derjenigen eines Planetenradgetriebes . Die Kodierscheiben brauchen keine Außenverzahnung zu tragen. Es ist auch möglich, daß jede Kodierscheibe starr mit einer außen verzahnten Scheibe
verbunden ist, gegen die der Zahnriemen läuft.

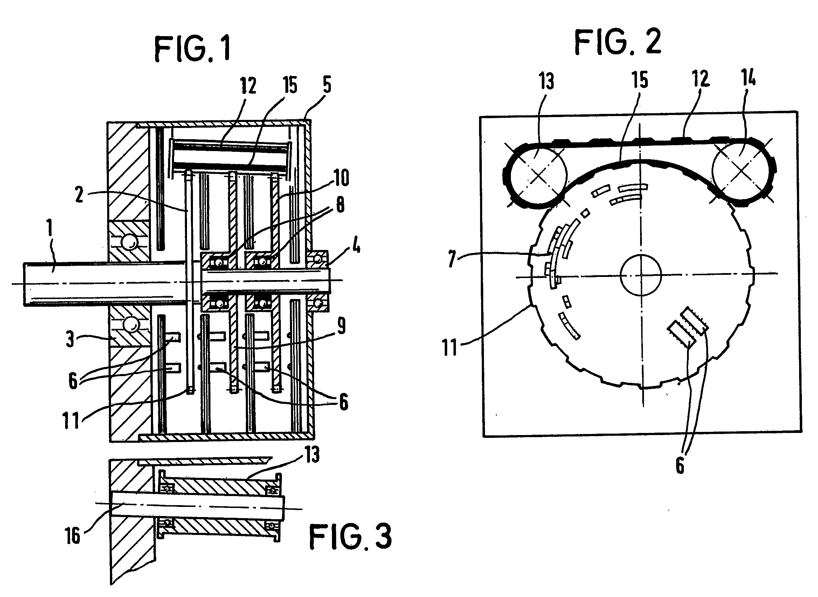

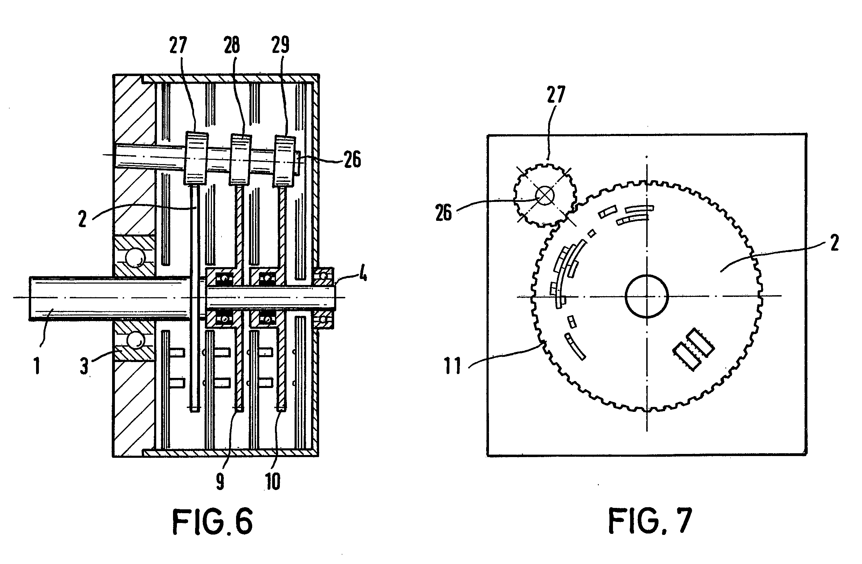

Bei der Ausführungsform nach Fig. 6 und 7 wurde der
Zahnriemen nach Fig. 1 bis 3 ersetzt durch ein Ritzel,
dessen Teilritzel 27, 28, 29 in Eingriff mit den
Kodierscheiben 2, 9, 10 steht. Die Achse 26 des Ritzels
weist eine Schräglage zur Achse der Welle 1 auf. Die Teilritzel 27, 28, 29 haben einen zueinander gleichen Durchmesser, während die Durchmesser der Scheiben 2, 9, 10 zueinander unterschiedlich sind.
Entsprechend der Ausführungsform nach Fig. 4 und 5 ist
es auch möglich, daß die Kodierscheiben jeweils gleichen
Durchmesser haben, jedoch das Ritzel konisch ausgebildet
ist.

In beiden Fällen ist es, wie an Hand der Fig. 1 bis 5
erläutert, möglich, daß die Zahnteilungen aller Kodierscheiben 2, 9, 10 und der Teilritzel 27, 28, 29 gleich
sind oder daß sie bei jeder Kodierscheibe und jedem
Teilritzel unterschiedlich sind. Eine konstante Zahnteilung ist bei der Ausführungsform nach Fig. 1 bis 3 und
eine unterschiedliche Zahnteilung bei der Ausführungsform nach Fig. 4 und 5 vorzuziehen.

9316/22
ch-ha                    -7-              Anm.: Hans Richter
                                          Augsburg, den 28. Juli 1981

Ansprüche

1. Winkelkodiervorrichtung mit mindestens zwei koaxial
   angeordneten Kodierscheiben, deren Kodes getrennt
   abgelesen werden, die an ihrem Umfang gezahnt und
   über ein Getriebe miteinander verbunden sind, dadurch  g e k e n n z e i c h n e t ,  daß das die
   Kodierscheiben (2, 9, 10, 16, 17, 18) miteinander
   verbindende Getriebe aus einem Ritzel (27, 28, 29)
   oder einem Zahnriemen (12, 19) besteht, und daß
   das Ritzel (27, 28, 29) bzw. der Zahnriemen (12, 19)
   eine Schräglage in bezug auf die Achse der Kodierscheiben ( 2, 9, 10, 16, 17, 18) aufweist.

2. Vorrichtung nach Anspruch 1, dadurch  g e k e n n -
   z e i c h n e t ,  daß  der Zahnriemen (12, 19) über
   zwei Umlenkrollen ( 13, 14, 20, 21) geführt ist, die
   den Zahnriemen (12, 19) gegen einen Teil des
   Umfangs der Kodierscheiben (2, 9, 10, 16, 17, 18) pressen.

3. Vorrichtung nach Anspruch 1 oder 2, dadurch  g e -
   k e n n z e i c h n e t ,  daß die Kodierscheiben ( 2,
   9, 10) unterschiedliche Durchmesser und Zähnezahl aufweisen und der Zahnriemen (12) eine Schräglage in bezug
   auf die Achse der Kodierscheiben (2, 9, 10) aufweist.

4. Vorrichtung nach Anspruch 1 oder 2, dadurch g e -
   k e n n z e i c h n e t, daß die Kodierscheiben
   (16, 17, 18) gleichen Durchmesser aufweisen,
   der Zahnriemen (19) konisch ausgebildet ist.

5. Vorrichtung nach Anspruch 1, dadurch g e k e n n -
   z e i c h n e t , daß die Kodierscheiben ( 2, 9, 10)
   unterschiedliche Durchmesser und Zähnezahl aufweisen
   und das Ritzel (27, 28, 29) eine Schräglage in bezug
   auf die Achse der Kodierscheiben (2, 9, 10) aufweist.

6. Vorrichtung nach Anspruch 1, dadurch g e k e n n -
   z e i c h n e t , daß die Kodierscheiben (2, 9, 10)
   gleichen Durchmesser aufweisen und das Ritzel konisch
   ausgebildet ist.

7. Vorrichtung nach einem der Ansprüche 3 bis 6, dadurch g e k e n n z e i c h n e t, daß die Kodierscheiben (2, 9, 10, 16, 17, 18) und der Zahnriemen
   (12, 19) bzw. das Ritzel (27, 28, 29) gleiche Zahnteilung aufweisen.

8. Vorrichtung nach einem der Ansprüche 3 bis 6, dadurch g e k e n n z e i c h n e t , daß der Zahnriemen (12, 19) bzw. das Ritzel (27, 28, 29) für
   jede Kodierscheibe (2, 9, 10, 16, 17, 18) eine andere
   Zahnteilung aufweist, die derjenigen der Kodierscheibe ( 2, 9, 10, 16, 17, 18) entspricht, mit der
   der Teil des Zahnriemens (12, 19) bzw. des Ritzels
   (27, 28, 29) in Eingriff steht.

9. Vorrichtung nach einem der Ansprüche 1 bis 8, dadurch
   g e k e n n z e i c h n e t, daß die Umfangsverzahnung (11)
   jeder Kodierscheibe ( 2, 9, 10, 16, 17, 18) an einer koaxialen zur Kodierscheibe (2, 9, 10, 16, 17, 18)
gelagerten und mit ihr starr verbundener Zahnscheibe
angeordnet ist, die in Kontakt mit dem Zahnriemen
(12, 19) bzw. dem Ritzel (27, 28, 29) steht.

## FIG.1

12  15  5

2

10

8

1

4

3

9

6

6

11

6

13

16

## FIG.3

## FIG. 2

13  15  12  14

7

11

6

FIG.4

FIG.5

FIG.7

FIG.6

Europäisches
Patentamt

**EUROPÄISCHER RECHERCHENBERICHT**

0046232

Nummer der Anmeldung

EP 81 10 6084

| **EINSCHLÄGIGE DOKUMENTE** | | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| | US - A - 2 532 970 (VAN DYKE)  *  Seite 3, Zeile 20 - Seite 4, Zeile 15; Figuren 1-4  * | 1,5 | H 03 K 13/18 G 01 D 5/249 |
| | US - A - 4 199 749 (RICHTER)  *  Seite 2, Zeilen 1-55; Seite 3, Zeile 1 - Seite 4, Zeile 57; Figuren 1-7  *  & DE - A - 2 718 336  & DE - A - 2 800 142 | 1,3-6 | |
| A | DE - A - 2 553 815 (ZSCHERPEL ELEK-TRONIK) | | **RECHERCHIERTE SACHGEBIETE (Int. Cl.³)**  H 03 K 13/18 G 01 D 13/14 13/252 13/32 13/34 13/36 G 06 M 1/38 3/10 |
| A | DE - A - 2 713 579 (ISLEF & HAGEN) | | |

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patent-familie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 20-11-1981 | GUIVOL |

EPA form 1503.1  06.78